# EUROPÄISCHE PATENTSCHRIFT

(11) **EP 3 422 035 B1**
(45) Veröffentlichungstag und Bekanntmachung des Hinweises auf die Patenterteilung: **11.09.2019**
(21) Anmeldenummer: 18179823.2
(22) Anmeldetag: 26.06.2018
(51) Int. Cl.: G01R 33/30, G01R 33/31

(54) **NMR-PROBENKOPF MIT MEHRTEILIGEM INSERT-UNTERTEIL**
NMR SAMPLE HEAD WITH A MULTI-PART INSERT LOWER PART
TÊTE DE SONDE RMN POURVUE DE SOUS-PIÈCE D'INSERTION EN PLUSIEURS PARTIES

(30) Priorität: 29.06.2017 DE 102017211016
(43) Veröffentlichungstag der Anmeldung: 02.01.2019
(73) Patentinhaber: Bruker BioSpin AG, 8117 Fällanden (CH)
(72) Erfinder: Meister, Roger, 8132 Hinteregg (CH); De Vries, Jonathan, 8052 Zürich (CH)
(74) Vertreter: Kohler Schmid Möbus Patentanwälte

(56) Entgegenhaltungen:
- DE-A1-102012 217 601
- US-A1- 2005 122 107

## Beschreibung

Die Erfindung betrifft einen temperierbaren NMR(=Kernspinresonanz)-Probenkopf mit einem um eine vertikale z-Achse angeordneten HF(=Hochfrequenz)-Spulensystem und einem senkrecht zur z-Achse angeordneten scheibenförmigen Insert-Unterteil, mit welchem die elektrischen und mechanischen Bauteile des NMR-Probenkopfes, insbesondere das HF-Spulensystem sowie HF- und HV(=Hochspannungs)-Leitungen, abgestützt und gehaltert sind.

Eine solche Anordnung ist bekannt aus der DE 10 2012 217 601 B4 (=Referenz [1].

### Hintergrund der Erfindung

Die NMR-Spektroskopie stellt ein leistungsfähiges Verfahren der instrumentellen Analytik dar. Dabei werden in eine Messprobe, die sich in einem starken, statischen Magnetfeld befindet, HF-Pulse eingestrahlt, und die HF-Reaktion der Messprobe wird vermessen. Sodann werden die Informationen integral über einen gewissen Bereich der Messprobe, das sogenannte aktive Volumen, gewonnen. Die Messprobe besteht in der Regel aus einem zylindrischen Probenröhrchen, das die zu untersuchende Messsubstanz in fester oder flüssiger Form enthält. Das Probenröhrchen befindet sich typischerweise in einem Spinner. Probenröhrchen und Spinner werden mit Hilfe eines Transportsystems von außerhalb des Magneten in den NMR-Probenkopf transportiert. Wenn sich das Probenröhrchen in der Messposition befindet, dann ist der Spinner innerhalb der Turbine. Die Turbine ermöglicht eine Rotation des Probenröhrchens. In der Messposition ist das Probenröhrchen von einer oder mehreren NMR-Spulen umgeben. Die innerste NMR-Spule hat einen Innendurchmesser, der möglichst wenig größer als der Außendurchmesser der Messprobe ist, da der Füllfaktor und damit die Empfindlichkeit der NMR-Spule vom Innendurchmesser abhängt und mit steigendendem Innendurchmesser abfällt.

Die Temperatur der Probe beeinflusst grundsätzlich die Ergebnisse der NMR-Messungen. Für hochwertige Messungen wird die Temperatur typischerweise mit Hilfe einer Temperiereinheit eingestellt und möglichst räumlich und zeitlich konstant über das aktive Messvolumen gehalten. NMR-Messungen werden typischerweise sowohl mit beheizten als auch mit gekühlten Proben durchgeführt. (Wenn die Probe unter Raumtemperatur gekühlt werden soll, wird ein hinreichend kalter Temperierfluidstrom im Zustromrohr geführt und vom Heizer auf die Solltemperatur aufgeheizt.) Der räumliche Temperatur-Gradient über das aktive Messvolumen und die zeitliche Stabilität der Probentemperatur haben einen wesentlichen Einfluss auf die Qualität der NMR-Messungen. Aus DE10 2010 029 080 A1 (=Referenz [2]) und DE 40 18 734 C2 (=Referenz [3] sind Temperiereinheiten zur Minimierung des Temperatur-Gradienten im aktiven Messvolumen bekannt.

NMR-Apparaturen mit einem auf eine Betriebstemperatur < 100 K gekühltem NMR-Kryoprobenkopf sowie mit Kühlkreislauf mit thermisch isolierten Kühlleitungen zwischen dem wärmeisolierten Gehäuse und dem NMR-Kryoprobenkopf beschreiben beispielsweise die EP 1 655 616 A1 oder die US 2006/0096301 A1.

### Nachteile des Standes der Technik

Bei den aus dem Stand der Technik bekannten temperierbaren Probenköpfen wird das -bislang stets einteilige- Insert-Unterteil vor allem aus Gründen des HF-Verhaltens aus Materialien wie Quarz oder Macor® hergestellt, die aber keine besonders hohe Bruchfestigkeit aufweisen. Daher kann es bei mechanischer Beanspruchung des Insert-Unterteils, etwa beim Ankoppeln eines Dewars zur Kühlung der Vorrichtung, leicht zu einem Bruch des Teils führen, was in der Regel sehr hohen Reparatur- und Austausch-Aufwand erforderlich macht. Auch thermische Spannungen können zu derartigen Komplikationen führen, wenn das herkömmliche Insert-Unterteil diesen Belastungen nicht dauerhaft standhält.

### Aufgabe der Erfindung

Der vorliegenden Erfindung liegt demgegenüber die Aufgabe zugrunde, einen NMR-Probenkopf der eingangs definierten Art mit möglichst einfachen technischen Maßnahmen so zu modifizieren, dass die oben aufgezählten Nachteile weitestgehend und vor allem dauerhaft vermieden werden und dass eine besonders hohe Bruchfestigkeit sowie eine hohe Resistenz gegen thermische Spannungen bei gleichzeitiger Gewährleistung der erforderlichen HF- und HV-Eigenschaften erzielt wird.

### Kurze Beschreibung der Erfindung

Diese komplexe Aufgabe wird auf ebenso überraschend einfache wie wirkungsvolle Weise dadurch gelöst, dass bei einem gattungsgemäßen NMR-Probenkopf mit den eingangs definierten Merkmalen das Insert-Unterteil mehrteilig gestaltet ist und mindestens zwei im montierten Zustand aneinander flächig anliegende, mechanisch nicht fest miteinander verbundene, im Wesentlichen scheibenförmige Teilelemente umfasst, die senkrecht zur z-Achse angeordnet sind, dass das erste Teilelement hinsichtlich seiner Materialwahl und seinem geometrischen Aufbau so gestaltet ist, dass es die Funktion einer elektrischen Isolation der durch das Insert-Unterteil hindurchgeführten HF- und HV-Leitungen erfüllt, wobei das erste Teilelement eine elektrische Leitfähigkeit Sigma < 10³ S/m aufweist, dass das erste Teilelement die Funktion einer mechanischen Halterung von auf dem Insert-Unterteil aufgebauten Bauteilen des NMR-Probenkopfes erfüllt, und dass das zweite Teilelement hinsichtlich seiner Materialwahl so gestaltet ist, dass das zweite Teilelement die Funktion einer mechanischen Halterung des ersten Teilelementes -inklusive seiner Aufbauten- an einem Hauptrahmen des NMR-Probenkopfes übernimmt, und aus einem duktilen Kunststoff oder Metall mit jeweils hoher mechanischer Bruchfestigkeit σ > 100 N/mm² und hoher Schmelztemperatur T_{S} > 250°C gefertigt ist.

Der erfindungsgemäße NMR-Probenkopf weist also im Gegensatz zur üblichen einteiligen Ausführung ein mehrteiliges Insert-Unterteil auf, bei welchem die unterschiedlichen Anforderungen und Funktionen in den einzelnen Teilelementen des Insert-Unterteils getrennt voneinander optimiert werden können. So ist hier das erste Teilelement so gestaltet, dass es die Funktion einer elektrischen Isolation der durch das Insert-Unterteil hindurchgeführten HF- und HV-Leitungen optimal erfüllen kann, während das zweite Teilelement aufgrund seiner erfindungsgemäßen Gestaltung optimal die Funktion einer mechanischen Halterung des ersten Teilelementes -inklusive seiner Aufbauten- an einem Hauptrahmen des NMR-Probenkopfes übernimmt. Auch die Aufnahme von thermischen Spannungen, die aufgrund der Temperierung des NMR-Probenkopfes auftreten, bewerkstelligt speziell das zweite Teilelement, welches insbesondere aufgrund einer entsprechenden Materialwahl eigens dafür ausgelegt werden kann.

Gerade aufgrund der durch die Erfindung eröffneten Möglichkeiten einer getrennten Optimierung der mechanischen und thermischen Eigenschaften des Insert-Unterteils einerseits und der HF- und HV-Eigenschaften andererseits wird dem Entwickler ein besonders wirkungsvolles Werkzeug zur ganz speziellen - und gegebenenfalls auch extremen-Auslegung eines NMR-Probenkopfes an die Hand gegeben.

An dieser Stelle sei ausdrücklich darauf hingewiesen, dass zwar in der Beschreibung der vorliegenden Erfindung sowie in den Patentansprüchen - der sprachlichen Einfachheit halber - stets von einer "vertikalen z-Achse" sowie von axialen Positionen "oberhalb" beziehungsweise "unterhalb" des NMR-Spulensystems die Rede ist, dass sich jedoch die Vorteile der Erfindung ebenso auch bei NMR-Systemen mit horizontaler oder schräg liegender z-Achse erzielen lassen. Die angegebenen axialen Positionen müssen dann nicht mehr notwendig "oberhalb" beziehungsweise "unterhalb" des NMR-Spulensystems liegen, sondern gegebenenfalls auch "rechts" oder "links" neben demselben. Jedenfalls spielt die Schwerkraft bei der Wirkungsweise der vorliegenden Erfindung eine untergeordnete Rolle.

### Bevorzugte Ausführungsformen der Erfindung

In der Praxis bewähren sich besonders Ausführungsformen des erfindungsgemäßen NMR-Probenkopfes, bei denen das erste Teilelement aus Keramik, aus Glaskeramik, insbesondere Macor®, aus Glas, aus Saphir oder aus Quarz gefertigt ist. Damit kann das erste Teilelement primär auf HF- und HV- Ansprüche optimiert werden, während bei dessen Gestaltung den mechanisch-/ thermischen- Beanspruchungen sekundäre Priorität gewidmet werden kann.

Vorteilhaft ist eine Klasse von Ausführungsformen des erfindungsgemäßen NMR-Probenkopfes, bei der das zweite Teilelement aus einem duktilen Werkstoff, insbesondere Polyetheretherketon (=PEEK), gefertigt ist.

Im Bereich des Temperiergas-Eintritts wird auf diese Weise vor allem das Risiko von thermisch bedingten Spannungsrissen reduziert. Durch die hohe Duktilität kann das Risiko von Spannungsrissen, bedingt durch die im Bereich der mechanischen Ankoppelung an den Hauptrahmen entstehender Kräfte, entscheidend verringert werden.

Eine weitere bevorzugte Ausführungsform des erfindungsgemäßen NMR-Probenkopfes ist dadurch gekennzeichnet, dass das zweite Teilelement eine oder mehrere die Scheibenebene vollständig durchgreifende Aussparungen aufweist, die in einem zusammen mit dem ersten Teilelement montierten Betriebszustand des NMR-Probenkopfes einen freien Durchgang in z-Richtung der durch das erste Teilelement hindurchgeführten HF- und HV-Leitungen freilassen. Die Aussparungen können frei gestaltet werden, so dass HF- und HV-Elemente weitest möglich von protonenhaltigen, duktilen und mechanisch beanspruchten "Stützelementen" entfernt sind, welche unerwünschtes Grundsignal verursachen können.

Besonders bevorzugt ist auch eine Klasse von Ausführungsformen, bei welchen eine Einrichtung zur Temperierung des NMR-Probenkopfes, insbesondere zur Kühlung auf kryogene Temperaturen TK < 200K, vorhanden ist, die vorzugsweise einen Dewar sowie Temperiergas-führende Durchgangskanäle umfasst.

Bei vorteilhaften Weiterbildungen dieser Klasse von Ausführungsformen ist eine Fluid- und/oder Gasdichtung zwischen dem zweiten Teilelement und den Temperiergas-führenden Durchgangskanälen angeordnet.

Besonders bevorzugt sind Varianten dieser Klasse von Ausführungsformen, die sich dadurch auszeichnen, dass die Fläche F, mit welcher im montierten Betriebszustand des NMR-Probenkopfes das erste scheibenförmige Teilelement auf dem zweiten scheibenförmigen Teilelement aufliegt, so groß gewählt ist, dass auch die Luftführenden Durchgangskanäle durch die Teilelemente fluid- und/oder gasdicht abgedichtet sind, insbesondere F > 0,10cm².

Bevorzugt ist auch eine Ausführungsform des erfindungsgemäßen NMR-Probenkopfs, die sich dadurch auszeichnet, dass die Teilelemente längs der z-Achse durchgängige Ausnehmungen aufweisen, insbesondere zur Durchführung eines Trimmers und/oder von NMR-Spulenbeinen und/oder von Gradientenzuleitungen und/oder eines Temperaturfühlers.

Andere vorteilhafte Ausführungsformen der Erfindung sind dadurch gekennzeichnet, dass das scheibenförmige erste Teilelement über das zweite Teilelement mechanisch an einem Hauptrahmen des NMR-Probenkopfes befestigt ist.

In der Praxis bewährt haben sich auch Ausführungsformen des erfindungsgemäßen NMR-Probenkopfes, bei welchen das Material des ersten Teilelements keine offene Porosität aufweist und wasserstofffrei ist.

Ganz besonders vorteilhaft sind Ausführungsformen der Erfindung, bei welchen der Verlustfaktor tan δ des ersten Teilelements kleiner ist als 0,01.

Zu bevorzugen sind auch Ausführungsformen der Erfindung, bei denen die Dielektrizitätszahl ε des ersten Teilelements kleiner ist als 10.

Bevorzugte Ausführungsformen erfindungsgemäßen NMR-Probenkopfs können zudem vorsehen, dass ein HF- Abschirmrohr vorhanden ist, welches in z-Richtung vorzugsweise mindestens zweiteilig, insbesondere mehrteilig aufgebaut ist.

In den Rahmen der vorliegenden Erfindung fällt auch eine NMR-Messanordnung mit einem erfindungsgemäßen NMR-Probenkopf der oben beschriebenen Art, die auch ein NMR-Magnetsystem, ein Shimsystem, eine Turbine sowie eine Vorrichtung zum Transport eines Probenröhrchens von außerhalb des NMR-Magnetsystems bis in die Messposition des Probenröhrchens im NMR-Probenkopf umfassen kann. Das erfindungsgemäße mehrteilige Insert-Unterteil kommt insbesondere im Gesamtsystem von NMR-Probenkopf, NMR-Magnet und Transportvorrichtung zum Tragen, da diese Kombination automatische Wechsel der Probenröhrchen erlaubt, die z.B. bei Hochdurchsatz-NMR-Anwendungen sehr wichtig sind. Die erfindungsgemäße Anordnung leistet für diese Anwendungen einen wichtigen Beitrag, da sie durch eine -körperliche- Trennung der Funktion einer Halterung und Befestigung mit Aufnahme von mechanischen Spannungen einerseits sowie einer Aufnahme von thermischen Spannungen andererseits eine gezielte individuelle Optimierung des jeweiligen Funktionsteils ermöglicht, wodurch spätere Beschädigungen des NMR-Probenkopfes im Betrieb verhindert werden können.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine schematische Seitenansicht auf eine Ausführungsform des erfindungsgemäßen NMR-Probenkopfs mit am Hauptrahmen befestigtem mehrteiligen scheibenförmigen Insert-Unterteil;
- Fig. 2: eine räumliche Ansicht einer Ausführungsform des mehrteiligen scheibenförmigen Insert-Unterteils schräg von unten; und
- Fig. 3: eine schematische Seitenansicht auf einen herkömmlichen NMR-Probenkopf mit einteiligem Insert-Unterteil nach dem Stand der Technik.

Die vorliegende Erfindung befasst sich mit dem Aufbau eines speziellen Insert-Unterteils bei einem temperierbaren Probenkopf einer NMR-Messanordnung die in der Regel ein NMR-Magnetsystem, ein Shimsystem, eine Turbine sowie eine Vorrichtung zum Transport eines Probenröhrchens von außerhalb des NMR-Magnetsystems bis in die Messposition des Probenröhrchens im NMR-Probenkopf aufweist.

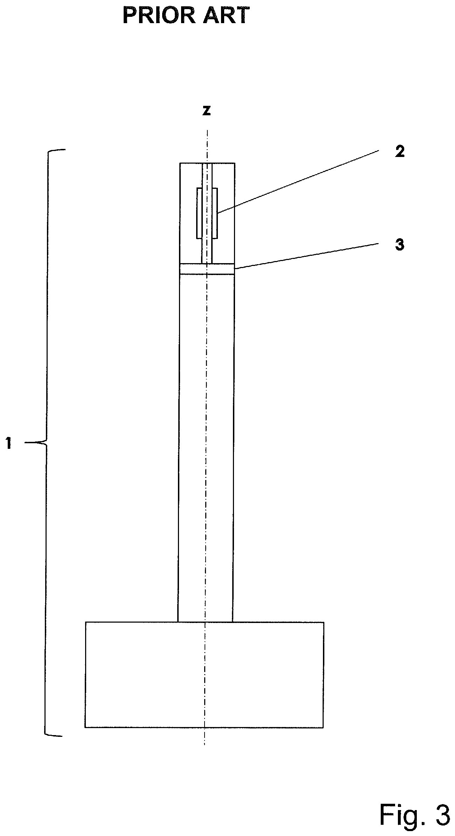

Ein solcher **NMR-Probenkopf 1** nach dem Stand der Technik, wie er in Fig. 3 gezeigt ist, umfasst gattungsgemäß ein um eine **vertikale Symmetrieachse z** eines -in der Zeichnung nicht näher dargestellten- NMR-Magnetsystems angeordnetes **HF-Spulensystem 2** sowie einem senkrecht zur z-Achse angeordneten scheibenförmigen **Insert-Unterteil 3**, mit welchem die elektrischen und mechanischen Bauteile des NMR-Probenkopfes 1, insbesondere das HF-Spulensystem 2 sowie HF- und HV-Leitungen, abgestützt und gehaltert sind.

Die vorliegende Erfindung ist dadurch charakterisiert, dass das Insert-Unterteil 3 mehrteilig gestaltet ist und mindestens zwei im montierten Zustand aneinander flächig anliegende, mechanisch nicht fest miteinander verbundene, im Wesentlichen scheibenförmige Teilelemente 3.1; 3.2 umfasst, die senkrecht zur z-Achse angeordnet sind, dass das **erste Teilelement 3.1** hinsichtlich seiner Materialwahl und seinem geometrischen Aufbau so gestaltet ist, dass es die Funktion einer elektrischen Isolation der durch das Insert-Unterteil 3 hindurchgeführten HF- und HV-Leitungen erfüllt, wobei das erste Teilelement 3.1 eine elektrische Leitfähigkeit Sigma < 10³ S/m aufweist, dass das erste Teilelement 3.1 die Funktion einer mechanischen Halterung von auf dem Insert-Unterteil 3 aufgebauten Bauteilen des NMR-Probenkopfes 1 erfüllt, und dass das **zweite Teilelement 3.2** hinsichtlich seiner Materialwahl so gestaltet ist, dass das zweite Teilelement 3.2 die Funktion einer mechanischen Halterung des ersten Teilelementes 3.1 -inklusive seiner Aufbauten- an einem **Hauptrahmen 7** des NMR-Probenkopfes 1 übernimmt, und aus einem duktilen Kunststoff oder Metall mit jeweils hoher mechanischer Bruchfestigkeit σ > 100 N/mm² und hoher Schmelztemperatur T_{S} > 250°C gefertigt ist.

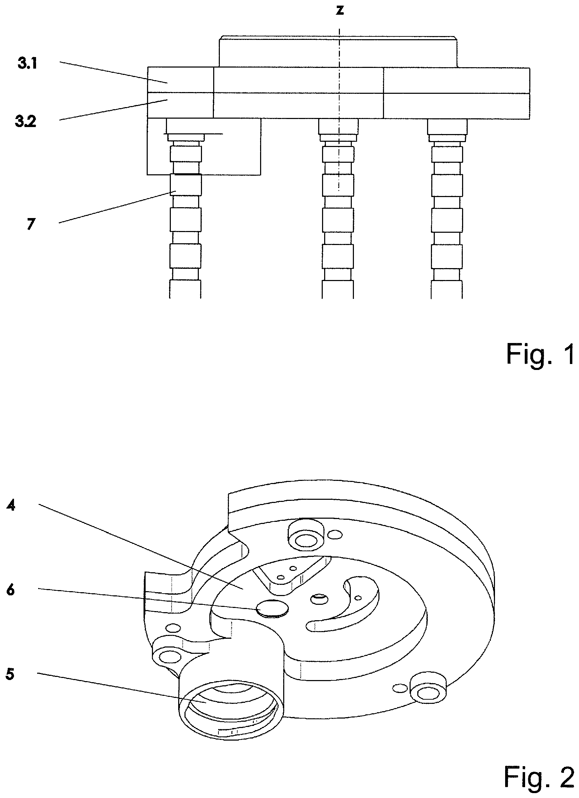

Eine Ausführungsform, bei der ein solches scheibenförmiges Teilelement 3.1 über das zweite Teilelement 3.2 mechanisch am Hauptrahmen 7 des NMR-Probenkopfes 1 befestigt ist, stellt Fig. 1 dar.

Wie in Fig. 2 sehr schön erkennbar, kann bei dem erfindungsgemäß gestalteten Insert-Unterteil 3 das zweite Teilelement 3.2 eine oder mehrere die Scheibenebene vollständig durchgreifende **Aussparungen 4** aufweisen, die in einem zusammen mit dem ersten Teilelement 3.1 montierten Betriebszustand des NMR-Probenkopfes 1 einen freien Durchgang in z-Richtung der durch das erste Teilelement 3.1 hindurchgeführten HF- und HV-Leitungen freilassen.

In den Figuren der Zeichnung nicht näher dargestellt -weil gegenüber dem bekannten Stand der Technik nicht wesentlich modifiziert- ist eine Einrichtung zur Temperierung des NMR-Probenkopfes 1, insbesondere zur Kühlung auf kryogene Temperaturen T_{K} < 200K, die vorzugsweise einen Dewar umfasst. Diese Temperier-Einrichtung kann Temperiergas-führende **Durchgangskanäle 5** aufweisen, wie in Fig. 2 gezeigt ist. Zwischen diesen Durchgangskanälen 5 und dem zweiten Teilelement 3.2 ist eine Fluid- und/oder Gasdichtung angeordnet.

Die Fläche F, mit welcher im montierten Betriebszustand des NMR-Probenkopfes 1 das erste scheibenförmige Teilelement 3.1 auf dem zweiten scheibenförmigen Teilelement 3.2 aufliegt, ist so groß gewählt, dass auch die Luftführenden Durchgangskanäle 5 durch die Teilelemente 3.1; 3.2 fluid- und/oder gasdicht abgedichtet sind, insbesondere F > 0,10cm².

Die Teilelemente 3.1; 3.2 weisen längs der z-Achse durchgängige **Ausnehmungen 6** auf, die insbesondere zur Durchführung eines Trimmers und/oder von NMR-Spulenbeinen und/oder von Gradientenzuleitungen und/oder eines Temperaturfühlers dienen.

In den Figuren der Zeichnung nicht eigens dargestellt sind Ausführungsformen der Erfindung, bei welchen ein HF- Abschirmrohr vorhanden ist, welches in z-Richtung vorzugsweise mindestens zweiteilig, insbesondere mehrteilig aufgebaut ist. Dabei kann ein erster Teilabschnitt des Abschirmrohres, welcher im Betriebszustand des NMR-Probenkopfes 1 eine Messprobe umgibt, eine einheitliche Länge in z-Richtung aufweisen, während ein zweiter Teilabschnitt des Abschirmrohres mit einer wählbaren, beliebigen Länge in z-Richtung gestaltet ist.

Das erste Teilelement 3.1 kann aus Keramik, aus Glaskeramik, insbesondere Macor®, aus Glas, aus Saphir oder aus Quarz gefertigt sein. Des Weiteren sollte das Material des ersten Teilelements 3.1 keine offene Porosität aufweisen und wasserstofffrei sein. Der Verlustfaktor tan δ des ersten Teilelements 3.1 sollte kleiner sein als 0,01, seine Dielektrizitätszahl ε kleiner als 10.

Das zweite Teilelement 3.2 sollte aus einem duktilen Werkstoff, insbesondere Polyetheretherketon (=PEEK), gefertigt sein.

### Bezugszeichenliste:

- 1: temperierbarer NMR-Probenkopf
- 2: HF-Spulensystem
- 3: scheibenförmiges Insert-Unterteil
- 3.1: erstes Teilelement
- 3.2: zweites Teilelement
- 4: durchgreifende Aussparungen im zweiten Teilelement
- 5: Temperierluft-führende Durchgangskanäle
- 6: durchgängige Ausnehmungen der Teilelemente
- 7: Hauptrahmen des NMR-Probenkopfes

- z: Symmetrieachse der Magnetspulenanordnung

### Referenzliste

Für die Beurteilung der Patentfähigkeit in Betracht gezogene Publikationen:
[1] DE 10 2012 217 601 B4
[2] DE10 2010 029 080 A1
[3] DE 40 18 734 C2
[4] EP 1 655 616 A1
[5] US 2006/0096301 A1

## Patentansprüche

1. Temperierbarer NMR-Probenkopf (1) mit einem um eine vertikale z-Achse angeordneten HF-Spulensystem (2) und einem senkrecht zur z-Achse angeordneten scheibenförmigen Insert-Unterteil (3), mit welchem die elektrischen und mechanischen Bauteile des NMR-Probenkopfes (1), insbesondere das HF-Spulensystem (2) sowie HF- und HV-Leitungen, abgestützt und gehaltert sind,
**dadurch gekennzeichnet,**
**dass** das Insert-Unterteil (3) mehrteilig gestaltet ist und mindestens zwei im montierten Zustand aneinander flächig anliegende, mechanisch nicht fest miteinander verbundene, im Wesentlichen scheibenförmige Teilelemente (3.1; 3.2) umfasst, die senkrecht zur z-Achse angeordnet sind,
**dass** das erste Teilelement (3.1) hinsichtlich seiner Materialwahl und seinem geometrischen Aufbau so gestaltet ist, dass es die Funktion einer elektrischen Isolation der durch das Insert-Unterteil (3) hindurchgeführten HF- und HV-Leitungen erfüllt, wobei das erste Teilelement (3.1) eine elektrische Leitfähigkeit Sigma < 10³ S/m aufweist,
**dass** das erste Teilelement (3.1) die Funktion einer mechanischen Halterung von auf dem Insert-Unterteil (3) aufgebauten Bauteilen des NMR-Probenkopfes (1) erfüllt,
und **dass** das zweite Teilelement (3.2) hinsichtlich seiner Materialwahl so gestaltet ist, dass das zweite Teilelement (3.2) die Funktion einer mechanischen Halterung des ersten Teilelementes (3.1) -inklusive seiner Aufbauten- an einem Hauptrahmen (7) des NMR-Probenkopfes (1) übernimmt, und aus einem duktilen Kunststoff oder Metall mit jeweils hoher mechanischer Bruchfestigkeit σ > 100 N/mm² und hoher Schmelztemperatur Ts > 250°C gefertigt ist.

2. NMR-Probenkopf nach Anspruch 1, **dadurch gekennzeichnet, dass** das erste Teilelement (3.1) aus Keramik, aus Glaskeramik, aus Glas, aus Saphir oder aus Quarz gefertigt ist.

3. NMR-Probenkopf nach Anspruch 1 oder 2, **dadurch gekennzeichnet, dass** das zweite Teilelement (3.2) aus einem duktilen Werkstoff, insbesondere Polyetheretherketon (=PEEK), gefertigt ist.

4. NMR-Probenkopf nach einem der vorhergehenden Ansprüche, **dadurch gekennzeichnet, dass** das zweite Teilelement (3.2) eine oder mehrere die Scheibenebene vollständig durchgreifende Aussparungen (4) aufweist, die in einem zusammen mit dem ersten Teilelement (3.1) montierten Betriebszustand des NMR-Probenkopfes (1) einen freien Durchgang in z-Richtung der durch das erste Teilelement (3.1) hindurchgeführten HF- und HV-Leitungen freilassen.

5. NMR-Probenkopf nach einem der vorhergehenden Ansprüche, **dadurch gekennzeichnet, dass** eine Einrichtung zur Temperierung des NMR-Probenkopfes (1), insbesondere zur Kühlung auf kryogene Temperaturen T_{K} < 200K, vorhanden ist, die vorzugsweise einen Dewar sowie Temperiergas-führende Durchgangskanäle (5) umfasst.

6. NMR-Probenkopf nach Anspruch 5, **dadurch gekennzeichnet, dass** eine Fluid- oder Gasdichtung zwischen dem zweiten Teilelement (3.2) und den Temperiergas-führenden Durchgangskanälen (5) angeordnet ist.

7. NMR-Probenkopf nach einem der Ansprüche 5 oder 6, **dadurch gekennzeichnet, dass** die Fläche F, mit welcher im montierten Betriebszustand des NMR-Probenkopfes (1) das erste scheibenförmige Teilelement (3.1) auf dem zweiten scheibenförmigen Teilelement (3.2) aufliegt, so groß gewählt ist, dass auch die Luftführenden Durchgangskanäle (5) durch die Teilelemente (3.1; 3.2) fluiddicht abgedichtet sind, insbesondere F > 0,10cm².

8. NMR-Probenkopf nach einem der vorhergehenden Ansprüche, **dadurch gekennzeichnet, dass** die Teilelemente (3.1; 3.2) längs der z-Achse durchgängige Ausnehmungen (6) aufweisen, insbesondere zur Durchführung eines Trimmers und/oder von NMR-Spulenbeinen und/oder von Gradientenzuleitungen und/oder eines Temperaturfühlers.

9. NMR-Probenkopf nach einem der vorhergehenden Ansprüche, **dadurch gekennzeichnet, dass** das scheibenförmige erste Teilelement (3.1) über das zweite Teilelement (3.2) mechanisch an einem Hauptrahmen (7) des NMR-Probenkopfes (1) befestigt ist.

10. NMR-Probenkopf nach einem der vorhergehenden Ansprüche, **dadurch gekennzeichnet, dass** das Material des ersten Teilelements (3.1) keine offene Porosität aufweist und wasserstofffrei ist.

11. NMR-Probenkopf nach einem der vorhergehenden Ansprüche, **dadurch gekennzeichnet, dass** der Verlustfaktor tan δ des ersten Teilelements (3.1) kleiner ist als 0,01.

12. NMR-Probenkopf nach einem der vorhergehenden Ansprüche, **dadurch gekennzeichnet, dass** die Dielektrizitätszahl ε des ersten Teilelements (3.1) kleiner ist als 10.

13. NMR-Probenkopf nach einem der vorhergehenden Ansprüche, **dadurch gekennzeichnet, dass** ein HF- Abschirmrohr vorhanden ist, welches in z-Richtung vorzugsweise mindestens zweiteilig, insbesondere mehrteilig aufgebaut ist.

14. NMR-Messanordnung mit einem NMR-Probenkopf (1) nach einem der vorhergehenden Ansprüche, mit einem NMR-Magnetsystem, mit einem Shimsystem, mit einer Turbine sowie mit einer Vorrichtung zum Transport eines Probenröhrchens von außerhalb des NMR-Magnetsystems bis in die Messposition des Probenröhrchens im NMR-Probenkopf (1).

## Claims

1. Temperature-controlled NMR probe head (1) comprising an RF coil system (2) arranged around a vertical z axis and a disc-shaped lower insert portion (3) arranged perpendicularly to the z axis, by means of which portion the electrical and mechanical components of the NMR probe head (1), in particular the RF coil system (2) as well as RF and HV lines, are supported and retained,
**characterized in that**
the lower insert portion (3) is formed of multiple parts and comprises at least two substantially disc-shaped sub-elements (3.1; 3.2) that are not mechanically rigidly interconnected, lie flat against one another in the mounted state and are arranged perpendicularly to the z axis,
**in that** the first sub-element (3.1), with regard to the choice of material and geometric structure thereof, is designed such that it fulfils the function of electrically insulating the RF and HV lines fed through the lower insert portion (3), the first sub-element (3.1) having an electrical conductivity sigma < 10³ S/m,
**in that** the first sub-element (3.1) fulfils the function of mechanically retaining components of the NMR probe head (1) constructed on the lower insert portion (3),
and **in that** the second sub-element (3.2), with regard to the choice of material thereof, is designed such that the second sub-element (3.2) takes over the function of mechanically retaining the first sub-element (3.1), including its structures, on a main frame (7) of the NMR probe head (1), and is made of a ductile plastics material or metal having a high mechanical breaking strength σ > 100 N/mm² and a high melting temperature Ts > 250°C in each case.

2. NMR probe head according to claim 1, **characterized in that** the first sub-element (3.1) is made of a ceramic material, of a glass ceramic material, of glass, of sapphire or of quartz.

3. NMR probe head according to either claim 1 or claim 2, **characterized in that** the second sub-element (3.2) is made of a ductile material, in particular polyether ether ketone (PEEK).

4. NMR probe head according to any of the preceding claims, **characterized in that** the second sub-element (3.2) comprises one or more recesses (4) that completely traverse the disc plane and, in an operating state of the NMR probe head (1) in which it is mounted together with the first sub-element (3.1), leave a free passage in the z direction of the RF and HV lines fed through the first sub-element (3.1).

5. NMR probe head according to any of the preceding claims, **characterized in that** a device is provided for controlling the temperature of the NMR probe head (1), in particular for cooling to cryogenic temperatures T_{K} < 200K, which device preferably comprises a dewar and temperature-control-gas-carrying through-channels (5).

6. NMR probe head according to claim 5, **characterized in that** a fluid or gas seal is arranged between the second sub-element (3.2) and the temperature-control-gas-carrying through-channels (5).

7. NMR probe head according to either claim 5 or claim 6, **characterized in that** the surface F, by means of which, in the mounted operating state of the NMR probe head (1), the first disc-shaped sub-element (3.1) rests on the second disc-shaped sub-element (3.2), is selected so as to be of such a size that the air-carrying through-channels (5) are also sealed in a fluid-tight manner by the sub-elements (3.1; 3.2), in particular F > 0,10cm².

8. NMR probe head according to any of the preceding claims, **characterized in that** the sub-elements (3.1; 3.2) comprise continuous recesses (6) along the z axis, in particular for feeding a trimmer and/or NMR coil legs and/or gradient supply lines and/or a temperature sensor therethrough.

9. NMR probe head according to any of the preceding claims, **characterized in that** the disc-shaped first sub-element (3.1) is mechanically attached to a main frame (7) of the NMR probe head (1) by means of the second sub-element (3.2).

10. NMR probe head according to any of the preceding claims, **characterized in that** the material of the first sub-element (3.1) does not have an open porosity and is hydrogen-free.

11. NMR probe head according to any of the preceding claims, **characterized in that** the loss factor tan δ of the first sub-element (3.1) is less than 0.01.

12. NMR probe head according to any of the preceding claims, **characterized in that** the dielectric constant ε of the first sub-element (3.1) is less than 10.

13. NMR probe head according to any of the preceding claims, **characterized in that** an RF shielding tube is provided which is preferably constructed in at least two parts, in particular in multiple parts, in the z direction.

14. NMR measuring arrangement comprising an NMR probe head (1) according to any of the preceding claims, comprising an NMR magnet system, comprising a shim system, comprising a turbine and comprising an apparatus for transporting a sample tube from outside the NMR magnet system into the measurement position of the sample tube in the NMR probe head (1).

## Revendications

1. Tête de mesure RMN (1) thermorégulable, comportant un système de bobines HF (2) disposé autour d'un axe z vertical et une partie inférieure d'insert (3) en forme de disque, disposée perpendiculairement à l'axe z, par laquelle les composants électriques et mécaniques de la tête de mesure RMN (1), en particulier le système de bobines HF (2) ainsi que les lignes HF et HT, sont soutenus et maintenus,
**caractérisé en ce**
**que** la partie inférieure d'insert (3) est réalisée en plusieurs parties et comprend au moins deux éléments partiels (3.1 ; 3.2) sensiblement en forme de disque qui, à l'état monté, sont en contact plan l'un avec l'autre sans être reliés mécaniquement l'un à l'autre de manière rigide, et qui sont disposés perpendiculairement à l'axe z,
**que** le premier élément partiel (3.1) est conçu, en ce qui concerne le choix de son matériau et sa structure géométrique, de telle sorte qu'il remplit la fonction d'une isolation électrique des lignes HF et HT qui passent à travers la partie inférieure d'insert (3), le premier élément partiel (3.1) ayant une conductivité électrique Sigma < 10³ S/m,
**que** le premier élément partiel (3.1) remplit la fonction d'un support mécanique de composants de la tête de mesure RMN (1) montés sur la partie inférieure d'insert (3)
et **que** le deuxième élément partiel (3).2) est conçu, en ce qui concerne le choix de son matériau, de telle sorte que le deuxième élément partiel (3.2) assume la fonction d'un support mécanique du premier élément partiel (3.1) - y compris des composants montés dessus - sur un châssis principal (7) de la tête de mesure RMN (1) et est réalisé en matière plastique ou en métal ductile ayant dans chaque cas une résistance mécanique à la rupture élevée σ > 100 N/mm² et une température de fusion élevée Ts > 250 °C.

2. Tête de mesure RMN selon la revendication 1, **caractérisée en ce que** le premier élément partiel (3.1) est réalisé en céramique, en vitrocéramique, en verre, en saphir ou en quartz.

3. Tête de mesure RMN selon la revendication 1 ou 2, **caractérisée en ce que** le deuxième élément partiel (3.2) est réalisé en un matériau ductile, en particulier en polyétheréthercétone (=PEEK).

4. Tête de mesure RMN selon l'une des revendications précédentes, **caractérisée en ce que** le deuxième élément partiel (3.2) présente un ou plusieurs évidements (4) qui traversent complètement le plan de disque et qui, dans un état de fonctionnement de la tête de mesure RMN (1) montée avec le premier élément partiel (3.1), laissent un libre passage dans la direction z aux lignes HF et HT qui passent à travers le premier élément partiel (3.1).

5. Tête de mesure RMN selon l'une des revendications précédentes, **caractérisée en ce qu'**un moyen de thermorégulation de la tête de mesure RMN (1), en particulier de refroidissement à des températures cryogéniques T_{K} < 200 K, est présent, qui comprend de préférence un dewar ainsi que des canaux de passage (5) conduisant le gaz de thermorégulation.

6. Tête de mesure RMN selon la revendication 5, **caractérisée en ce qu'**un joint d'étanchéité aux fluides ou aux gaz est disposé entre le deuxième élément partiel (3.2) et les canaux de passage (5) conduisant le gaz de thermorégulation.

7. Tête de mesure RMN selon l'une des revendications 5 ou 6, **caractérisée en ce que** la surface F, par laquelle le premier élément partiel en forme de disque (3.1) repose sur le deuxième élément partiel en forme de disque (3.2) à l'état de fonctionnement monté de la tête de mesure RMN (1), est choisie assez grande pour que les canaux de passage (5) conduisant de l'air qui traversent les éléments partiels (3.1 ; 3.2) soient également rendus étanches aux fluides, en particulier F > 0,10 cm².

8. Tête de mesure RMN selon l'une des revendications précédentes, **caractérisée en ce que** les éléments partiels (3.1 ; 3.2) présentent des évidements continus (6) le long de l'axe z, en particulier pour le passage d'un trimmer et/ou de branches de bobine RMN et/ou de lignes d'alimentation à gradient et/ou d'un capteur de température.

9. Tête de mesure RMN selon l'une des revendications précédentes, **caractérisée en ce que** le premier élément partiel en forme de disque (3.1) est fixé mécaniquement à un châssis principal (7) de la tête de mesure RMN (1) par l'intermédiaire du deuxième élément partiel (3.2).

10. Tête de mesure RMN selon l'une des revendications précédentes, **caractérisée en ce que** le matériau du premier élément partiel (3.1) ne présente aucune porosité ouverte et est exempt d'hydrogène.

11. Tête de mesure RMN selon l'une des revendications précédentes, **caractérisée en ce que** le facteur de perte tan δ du premier élément partiel (3.1) est inférieur à 0,01.

12. Tête de mesure RMN selon l'une des revendications précédentes, **caractérisée en ce que** la constante diélectrique ε du premier élément partiel (3.1) est inférieure à 10.

13. Tête de mesure RMN selon l'une des revendications précédentes, **caractérisée en ce qu'**un tube de blindage HF est présent, qui est de préférence constitué au moins de deux parties, en particulier de plusieurs parties, dans la direction z.

14. Agencement de mesure RMN avec une tête de mesure RMN (1) selon l'une des revendications précédentes, avec un système magnétique RMN, avec un système magnétique RMN, avec un système de shim, avec une turbine et avec un dispositif pour transporter un tube à échantillon de l'extérieur du système magnétique RMN vers la position de mesure du tube à échantillon dans la tête de mesure RMN (1).
